# EUROPEAN PATENT APPLICATION

(11) **EP 4 625 708 A1**
(43) Date of publication of application: **01.10.2025**
(21) Application number: 25153525.8
(22) Date of filing: 23.01.2025
(51) Int. Cl.: H01R 12/70

(54) **MOUNTED SUBSTRATE AND ELECTRONIC APPARATUS**

(30) Priority: 25.03.2024 JP 2024047722
(71) Applicant: Lenovo (Singapore) Pte. Ltd., New Tech Park 556741 (SG)
(72) Inventor: MIZOGUCHI, Fumitake, Yokohama-shi, 220-0012 (JP); OHSAWA, Osamu, Yokohama-shi, 220-0012 (JP); BANDOH, Masaaki, Yokohama-shi, 220-0012 (JP); SHIBAYAMA, Yoshiyuki, Yokohama-shi, 220-0012 (JP); NAKATA, Munefumi, Yokohama-shi, 220-0012 (JP); SEINO, Satoshi, Yokohama-shi, 220-0012 (JP)
(74) Representative: Openshaw & Co.

(57) **Abstract**

Provided is a mounted substrate and an electronic apparatus each of which can achieve easy replacement of a receptacle connector.

A mounted substrate includes: a substrate having a mounting surface; a surface mount connector having an inner surface provided with a contact point, having a connector connecting hole opened along a surface direction of the substrate, and mounted on the mounting surface of the substrate; and a receptacle connector having a plug connection opening to which a plug is connected, the receptacle connector including a relay connector detachably connected to the connector connecting hole. The connector connecting hole has an opening edge portion including a first edge portion placed closer to the mounting surface side in a height direction of the connector connecting hole, and a second edge portion placed opposite from the first edge portion in the height direction. The second edge portion is disposed on a deep side from the first edge portion in a depth direction of the connector connecting hole.

## Description

### BACKGROUND OF THE INVENTION

### Field of the Invention

The present invention relates to a mounted substrate including a receptacle connector, and an electronic apparatus including the mounted substrate.

### Description of the Related Art

An electronic apparatus such as a laptop PC or a tablet PC includes a receptacle connector as an I/O connector on a lateral surface of a flat chassis. The receptacle connector is often provided on an edge of a main substrate (see Japanese Unexamined Patent Application Publication No. 2019-36484).

### SUMMARY OF THE INVENTION

In recent years, as the electronic apparatus as described above, a product superior in maintainability has been desired from the viewpoint of ESG (Environment, Social, Governance). In this regard, it is desirable that the receptacle connector be easily replaceable. Particularly, in a case where receptacle connectors conform to the USB Type-C technical standard or the like that is frequently used, the number of receptacle connectors resulting in failure is large, and therefore, it is still more desirable that such receptacle connectors be easily replaceable.

In this regard, receptacle connectors are relatively inexpensive. However, in a case where a receptacle connector is mounted on a main substrate by soldering, the main substrate must be replaced to replace the connector. As a result, a cost burden on a user increases, and environmental performance is also affected.

The present invention is accomplished in view of the above technical problem, and an object of the present invention is to provide a mounted substrate and an electronic apparatus each of which can achieve easy replacement of a receptacle connector.

A mounted substrate according to the first aspect of the present invention includes: a substrate having a mounting surface; a surface mount connector having an inner surface provided with a contact point, having a connector connecting hole opened along a surface direction of the substrate, and mounted on the mounting surface of the substrate; and a receptacle connector having a plug connection opening to which a plug is connected, the receptacle connector including a relay connector detachably connected to the connector connecting hole. The connector connecting hole has an opening edge portion including a first edge portion placed closer to the mounting surface side in a height direction of the connector connecting hole, and a second edge portion placed opposite from the first edge portion in the height direction. The second edge portion is disposed on a deep side from the first edge portion in a depth direction of the connector connecting hole.

An electronic apparatus according to the second aspect of the present invention includes: a chassis; and a mounted substrate supported on the chassis. The mounted substrate includes: a substrate having a mounting surface; a surface mount connector having an inner surface provided with a contact point, having a connector connecting hole opened along a surface direction of the substrate, and mounted on the mounting surface of the substrate; and a receptacle connector having a plug connection opening to which a plug is connected, the receptacle connector including a relay connector detachably connected to the connector connecting hole. The connector connecting hole has an opening edge portion including a first edge portion placed closer to the mounting surface side in a height direction of the connector connecting hole, and a second edge portion placed opposite from the first edge portion in the height direction. The second edge portion is disposed on a deep side from the first edge portion in a depth direction of the connector connecting hole.

The aspects of the present invention can achieve easy replacement of a receptacle connector.

### BRIEF DESCRIPTION OF THE DRAWINGS

FIG. 1 is a perspective view of an electronic apparatus according to one embodiment;
FIG. 2 is a perspective view of a receptacle connector and a surface mount connector viewed from outside and diagonally above;
FIG. 3 is a sectional perspective view of the receptacle connector and the surface mount connector viewed from outside and diagonally below;
FIG. 4 is a schematic side sectional view of a chassis around the receptacle connector and its peripheral area;
FIG. 5 is a view in which the receptacle connector illustrated in FIG. 4 is moved inward;
FIG. 6 is a view in which the receptacle connector illustrated in FIG. 5 is tilted up;
FIG. 7 is a view in which the receptacle connector illustrated in FIG. 6 is pulled out of the surface mount connector;
FIG. 8 is a schematic plan sectional view of the receptacle connector and the surface mount connector; and
FIG. 9 is a view illustrating a state where the receptacle connector illustrated in FIG. 8 is positioned in its width direction on a horizontal plane.

### DETAILED DESCRIPTION OF THE INVENTION

The following will describe details of a preferred embodiment of a mounted substrate and an electronic apparatus according to the present invention with reference to the attached drawings.

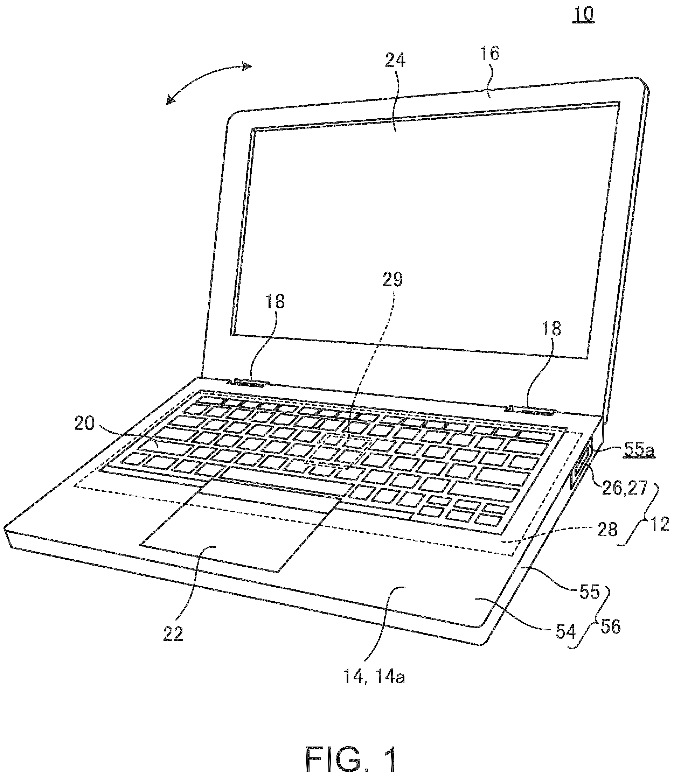

FIG. 1 is a perspective view of an electronic apparatus 10 according to one embodiment. The electronic apparatus 10 is provided with a mounted substrate 12 according to one embodiment. The mounted substrate 12 is incorporated into a chassis 14 of the electronic apparatus 10. The following describes an embodiment of the present invention with reference to the electronic apparatus 10 as a laptop PC. The present invention can be applied to electronic apparatuses other than the laptop PC, e.g., a desktop PC, a tablet PC (a tablet terminal), and the like.

The electronic apparatus 10 includes the chassis 14, a cover 16, and a hinge 18. The chassis 14 and the cover 16 are coupled to each other via the hinge 18 in such a manner to be rotatable relative to each other.

The chassis 14 is provided with a keyboard 20 and a touch pad 22. Various electronic parts such as a battery device, a storage device, a speaker, and an antenna can be provided inside the chassis 14 other than the mounted substrate 12. A display device 24 is provided on a front surface of the cover 16 in such a manner as to cover most of the area of the front surface. The display device 24 can be constituted by a liquid crystal display, an organic EL display, or the like, for example. A speaker, a camera, and the like can be provided on the cover 16.

The mounted substrate 12 is supported inside the chassis 14. The mounted substrate 12 can include a receptacle connector 26, a surface mount connector 27, and a substrate 28. The mounted substrate 12 is a connector-substrate assembly in which the receptacle connector 26 is mounted on the substrate 28 via the surface mount connector 27.

The substrate 28 is a main substrate (a mother board) in the electronic apparatus 10. The substrate 28 is a printed circuit board (PCB). The substrate 28 extends generally over right and left ends of the chassis 14 inside the chassis 14. A CPU 29 configured to control the whole electronic apparatus 10 is mounted on the substrate 28. The surface mount connector 27 is mounted on the substrate 28. The receptacle connector 26 is mounted on the substrate 28 via the surface mount connector 27. The substrate 28 on which the surface mount connector 27 is mounted may be a sub-substrate different from the main substrate.

For convenience of this description, around the receptacle connector 26, a lateral side of the chassis 14 is defined as outside, and an inner portion of the chassis 14 which inner portion is opposite from the outside is defined as inside. On the basis of the substrate 28, a mounting surface 28a side on which the surface mount connector 27 is provided is defined as top, and its opposite side is defined as bottom. The definitions of the top and the bottom may be reversed to the top and the bottom of the chassis 14 illustrated in FIG. 1. That is, when the top and the bottom on the basis of the substrate 28 are applied to the chassis 14, a surface provided with the keyboard 20 may become the bottom. In terms of the receptacle connector 26 and the surface mount connector 27, a direction perpendicular to the inside-outside direction and the top-bottom direction is defined as a width direction. The names of these directions are for the sake of convenience for description, and the usage of the electronic apparatus 10 is not limited to this.

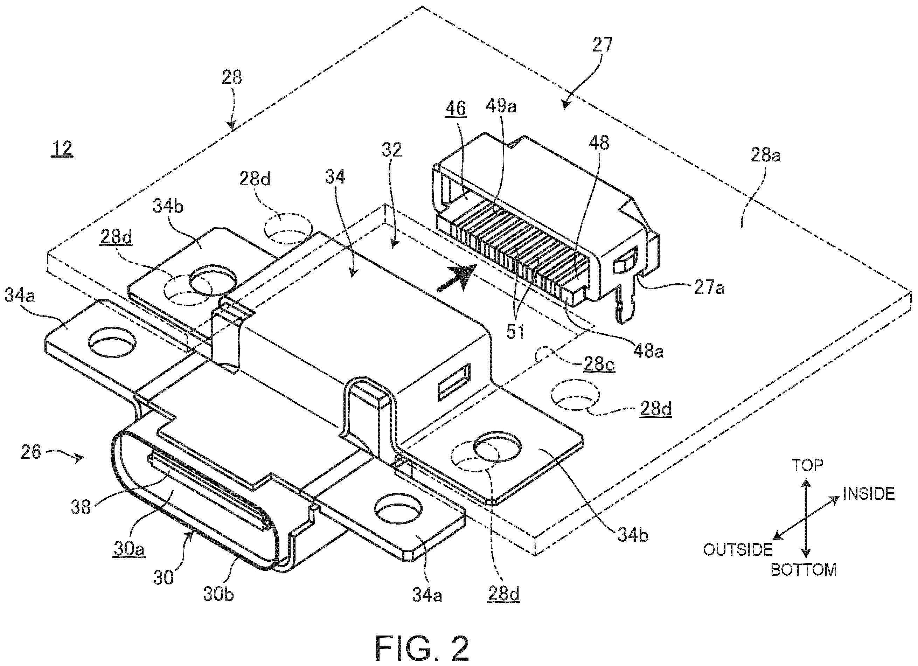

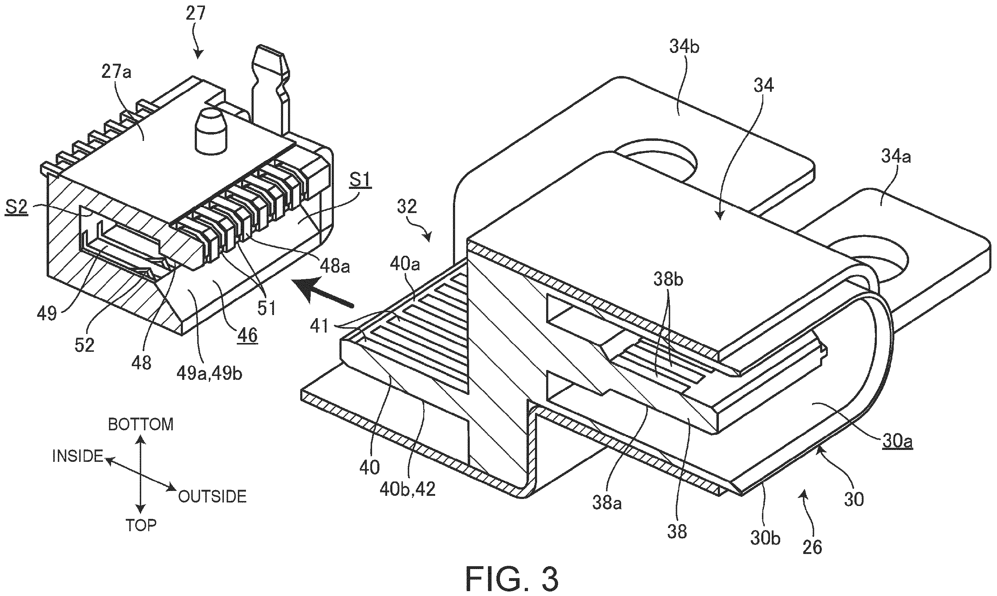

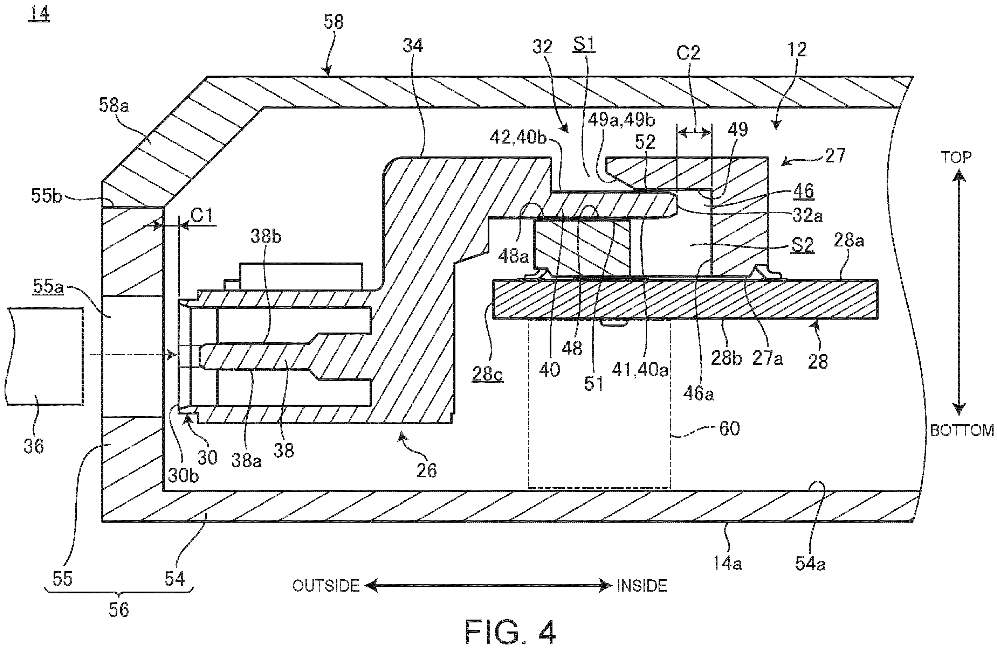

FIG. 2 is a perspective view of the receptacle connector 26 and the surface mount connector 27 viewed from outside and diagonally above. FIG. 3 is a sectional perspective view of the receptacle connector 26 and the surface mount connector 27 viewed from outside and diagonally below. FIG. 4 is a schematic side sectional view of the chassis 14 around the receptacle connector 26 and its peripheral area.

First described is an exemplary configuration of the receptacle connector 26.

As illustrated in FIGS. 2 to 4, the receptacle connector 26 is a connector in conformity with the USB type-C standard, for example. The receptacle connector 26 can be used for data transmission or charge. The receptacle connector 26 may also conform to the HDMI (registered trademark) standard or the like. The receptacle connector 26 is mounted on the substrate 28 via the surface mount connector 27. Hereby, the receptacle connector 26 is not soldered to the substrate 28, so that the receptacle connector 26 is attachable and detachable.

The receptacle connector 26 includes a plug hold cylindrical body 30, a relay connector 32, and a shell 34.

The relay connector 32 of the receptacle connector 26 is connected to the surface mount connector 27 mounted on the mounting surface 28a. Hereby, the plug hold cylindrical body 30 is disposed to fit into a cutout 28c formed in the substrate 28. This allows the receptacle connector 26 to be mounted on the mounting surface 28a of the substrate 28 by a so-called mid-mount method.

The plug hold cylindrical body 30 is a metal tubular body. The plug hold cylindrical body 30 has a flat elliptical shape with four round corners. The plug hold cylindrical body 30 is on the outermost side of the receptacle connector 26 and is placed below the relay connector 32.

A vertical wall 55 forming a lateral surface of the chassis 14 has a through-hole (a connector hole) 55a (also see FIG. 1). The plug hold cylindrical body 30 is disposed to face the through-hole 55a. Hereby, a plug connection opening 30a of the plug hold cylindrical body 30 is exposed to outside the chassis 14 via the through-hole 55a. A plug 36 can be inserted in and connected to the plug connection opening 30a (see FIG. 4). The plug 36 is a plug connector attached to a cable or a device. The connection standard for the plug connection opening 30a and the plug 36 conforms to the USB type-C standard, for example. The plug 36 can be inserted into and connected to the plug connection opening 30a regardless of face-up or face-down.

A board piece 38 having a tongue shape is provided inside the plug hold cylindrical body 30. The board piece 38 has contact points 38a, 38b on a top surface and a bottom surface thereof, respectively. A terminal of the plug 36 makes contact with each of the contact points 38a, 38b. The contact points 38a, 38b are each constituted by a plurality of metallic pins arranged in parallel in the width direction of the board piece 38. The contact points 38a, 38b are connected to terminals 41, 42 of the relay connector 32 by use of respective electrode lines, respectively. The contact points 38a, 38b and the terminals 41, 42 each have 24 metallic pins, for example.

The relay connector 32 is on the innermost side of the receptacle connector 26. The relay connector 32 is placed above the mounting surface 28a. The relay connector 32 can have a plug structure. The relay connector 32 can be detachably connected to a connector connecting hole 46 of the surface mount connector 27.

The relay connector 32 can include a board piece 40 having a tongue shape, a first terminal 41 provided on a bottom surface (one surface 40a) of the board piece 40, and a second terminal 42 provided on a top surface (the other surface 40b) of the board piece 40. The terminals 41, 42 are each constituted by a plurality of metallic pins arranged in parallel in the width direction of the board piece 40, for example. The terminals 41, 42 each have 12 metallic pins, for example.

The shell 34 is a thin metal plate component. The shell 34 covers an outer peripheral surface of the plug hold cylindrical body 30 except the plug connection opening 30a, and a top surface and a lateral surface of the relay connector 32. The shell 34 includes a pair of fixing pieces 34a, 34a and a pair of fixing pieces 34b, 34b in the width direction. The fixing pieces 34a project to the opposite directions from respective lateral surfaces of the plug hold cylindrical body 30. The fixing pieces 34b project to the opposite directions from respective lateral surfaces of the relay connector 32. The fixing pieces 34a, 34b can be used to fix the receptacle connector 26 to the substrate 28. The fixing pieces 34a, 34b each has a screw insertion hole. The substrate 28 has a screw insertion hole 28d formed at a position corresponding to each of the fixing pieces 34a, 34b (see FIG. 2). The fixing pieces 34b may be omitted.

A stud 60 is formed in a standing manner on a plate portion 54 forming an inner surface of the chassis 14 (see FIG. 4). The stud 60 has an internal thread formed on a top surface (an upper end surface) thereof. The top surface of the stud 60 abuts with a back surface 28b of the substrate 28 which back surface 28b is opposite from the mounting surface 28a. A screw passed through the screw insertion hole of the fixing piece 34a, 34b and the screw insertion hole 28d of the substrate 28 is threadedly engaged with the internal thread of the stud 60. Hereby, the shell 34 is fastened to the substrate 28, and the receptacle connector 26 is fixed to the substrate 28. At the same time, a portion of the substrate 28 which portion is around the receptacle connector 26 is also supported on the chassis 14.

Next will be described an exemplary configuration of the surface mount connector 27.

As illustrated in FIGS. 2 to 4, the surface mount connector 27 can be mounted such that a connection surface 27a of the surface mount connector 27 is fixed to the mounting surface 28a of the substrate 28 by soldering. The relay connector 32 of the receptacle connector 26 can be detachably connected to the surface mount connector 27. In the present embodiment, the relay connector 32 has a plug structure, and therefore, the surface mount connector 27 has a socket structure. The surface mount connector 27 and the relay connector 32 can each be constituted by a board-to-board connector.

The surface mount connector 27 has the connector connecting hole 46. The connector connecting hole 46 extends along a surface direction of the substrate 28 and is opened to face outside. The connector connecting hole 46 has an opening edge portion including a first edge portion 48a and a second edge portion 49a. The first edge portion 48a is an edge portion closer to the mounting surface 28a side (the bottom side). The second edge portion 49a is an edge portion on the opposite side (the top side) from the mounting surface 28a side. The edge portions 48a, 49a extend in the width direction of the connector connecting hole 46.

Contact points 51, 52 are provided on an inner surface of the connector connecting hole 46. The contact points 51, 52 make contact with the terminals 41, 42 of the relay connector 32 in a conducting manner, respectively.

The inner surface of the connector connecting hole 46 includes a first inner surface 48 and a second inner surface 49. The first inner surface 48 is a bottom surface on one side (the bottom side) of the connector connecting hole 46 in its height direction (the top-bottom direction). The first inner surface 48 extends inwardly from the first edge portion 48a in a depth direction (the inside-outside direction) of the connector connecting hole 46. The second inner surface 49 is a ceiling surface on the other side (the top side) of the connector connecting hole 46 in the height direction. The second inner surface 49 extends inwardly from the second edge portion 49a in the depth direction of the connector connecting hole 46.

The first contact point 51 is provided on the first inner surface 48. The second contact point 52 is provided on the second inner surface 49. Each of the contact points 51, 52 is connected to a signal line or a ground pattern formed on the substrate 28. The contact points 51, 52 are each constituted by a plurality of metallic pins arranged in parallel in the width direction of the connector connecting hole 46. The contact points 51, 52 each have 12 metallic pins, for example. The terminals 41, 42 of the relay connector 32 make contact with the contact points 51, 52 in a conducting manner.

As illustrated in FIG. 4, the second edge portion 49a is disposed on a deep side relative to the first edge portion 48a in the depth direction of the connector connecting hole 46. In other words, the first edge portion 48a is disposed on an opening side relative to the second edge portion 49a in the depth direction of the connector connecting hole 46. Accordingly, the first edge portion 48a as a lower jaw of the connector connecting hole 46 projects outwardly from the second edge portion 49a as an upper jaw thereof. Hereby, the opening edge portion of the connector connecting hole 46 forms an open space S1 opened upward. The open space S1 is a space allowing a root portion of the relay connector 32 inserted into the connector connecting hole 46 to swing upward.

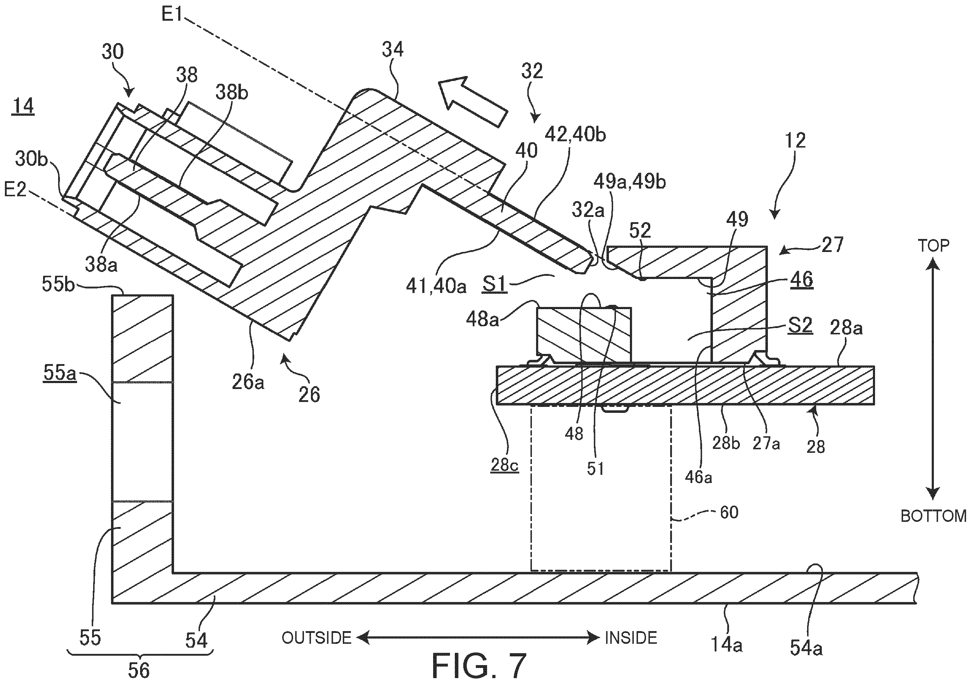

The second edge portion 49a facing the open space S1 has an inclined surface 49b. The inclined surface 49b is gradually inclined in a direction (upward) separating from the mounting surface 28a, from the deep side (the inside) of the connector connecting hole 46 toward the opening side (the outside) thereof. The inclination angle of the inclined surface 49b from the surface direction of the substrate 28 is not limited but can be set to about 20 degrees to 40 degrees, for example. In the present embodiment, the inclination angle is about 30 degrees. The inclination angle of the inclined surface 49b can be designed in consideration of a standing height of the vertical wall 55 (described later), the height of the receptacle connector 26 in the up-down direction, and the like. It is desirable that the inclination angle of the inclined surface 49b be an angle at which extension lines E1, E2 in FIG. 7 do not intersect with the vertical wall 55, for example.

The connector connecting hole 46 can have an expansion space S2 formed such that a portion of the first inner surface 48 which portion is on the deep side from the first contact point 51 is recessed toward the mounting surface 28a side (the bottom side). The expansion space S2 is a space formed by expanding a deep portion of the connector connecting hole 46 downward. The expansion space S2 is a space allowing a distal end portion of the relay connector 32 inserted into the connector connecting hole 46 to swing downward.

As illustrated in FIG. 4, the chassis 14 can include a chassis member 56 including the plate portion 54 and the vertical wall 55, and a cover material 58.

The chassis member 56 can have a shallow bathtub shape by forming the vertical wall 55 in an outer peripheral edge portion of the plate portion 54. The plate portion 54 forms an operation surface 14a of the chassis 14. The operation surface 14a is a surface on which the keyboard 20 and the touch pad 22 are exposed (see FIG. 1). The plate portion 54 has an inner surface 54a on which the stud 60 can be formed in a standing manner. The studs 60 are placed in positions corresponding to at least four fixing pieces 34a, 34b. As described above, the studs 60 can be used to fasten the receptacle connector 26 to the substrate 28. A portion of the substrate 28 which portion is not around the receptacle connector 26 is also supported on the inner surface 54a of the plate portion 54 as appropriate.

The vertical wall 55 stands upward from an outer peripheral edge portion of the plate portion 54. The vertical wall 55 forming the lateral surface of the chassis 14 has the through-hole 55a (also see FIG. 1). The plug connection opening 30a of the receptacle connector 26 faces the through-hole 55a. The through-hole 55a is an opening via which the plug 36 is connected to the plug connection opening 30a.

The cover material 58 is a plate-shaped member for blocking the opening of the chassis member 56. A tapered portion 58a can be provided in an edge portion of the cover material 58. The tapered portion 58a is inclined inwardly from a distal end (an upper end 55b) of the vertical wall 55. The receptacle connector 26 can be disposed such that a step formed in the top-bottom direction between the relay connector 32 and the plug hold cylindrical body 30 is placed below an inner surface of the tapered portion 58a.

As illustrated in FIG. 4, the receptacle connector 26 is mounted on the substrate 28 via the surface mount connector 27 and can be supported on the substrate 28 and the chassis 14 via the studs 60. In this state, a predetermined clearance C1 can be provided between an open end (the outer end surface 30b) of the plug connection opening 30a and the inner surface of the vertical wall 55. The clearance C1 is an opposed distance between the vertical wall 55 and the plug connection opening 30a. The clearance C1 can be 0.2 mm, for example. The distal end of the plug hold cylindrical body 30 may make contact with the inner surface of the vertical wall 55 or may be inserted into the through-hole 55a. In this case, the clearance C1 is zero or becomes negative.

In this state, a predetermined clearance C2 can be provided between a depth surface 46a of the connector connecting hole 46 and a distal end surface 32a of the relay connector 32. The clearance C2 can be 0.5 mm, for example. That is, the clearance C2 can be set larger than the clearance C1. The clearance C2 forms a space in which the relay connector 32 is moved towards the deep side of the connector connecting hole 46 at the time of a removal operation and an attachment operation of the receptacle connector 26 (described later).

Next will be described the removal operation of the receptacle connector 26 and its operation-effect.

In a state where the receptacle connector 26 is incorporated in the chassis 14, the receptacle connector 26 is mounted on the substrate 28 via the surface mount connector 27, as illustrated in FIG. 4. The fixing pieces 34a, 34b are fixed to the substrate 28 with screws.

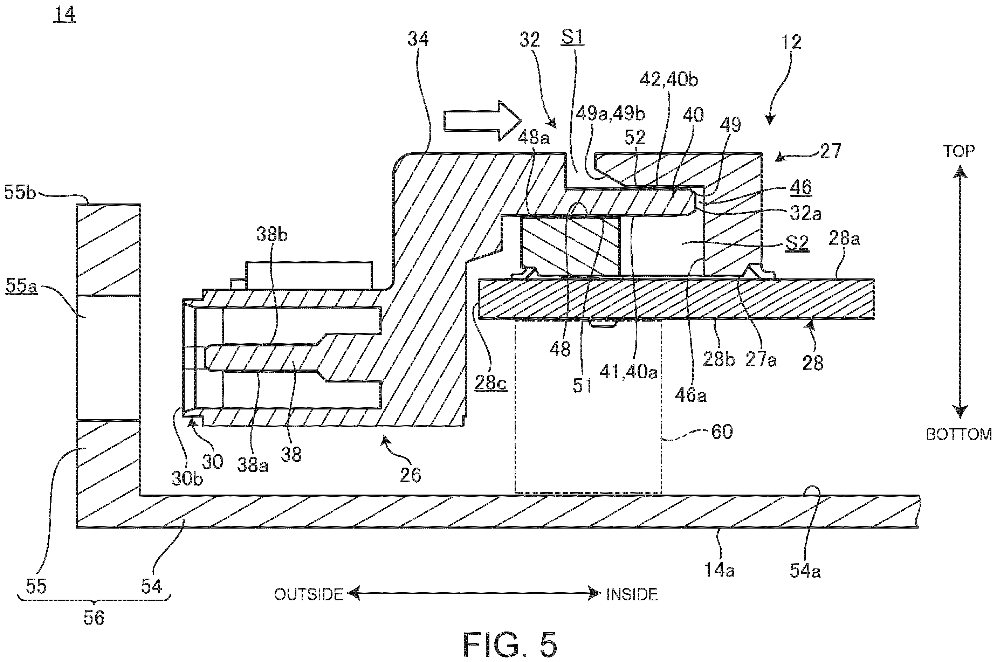

When the receptacle connector 26 breaks down and is to be removed and replaced from this state, for example, the cover material 58 is first removed from the chassis member 56 (see FIG. 5). Hereby, the inside of the chassis 14 is exposed, so that the receptacle connector 26 becomes accessible. Respective screws fastening the fixing pieces 34a, 34b to the substrate 28 are removed. This causes the receptacle connector 26 to be supported on the substrate 28 only at a connecting portion between the relay connector 32 and the surface mount connector 27.

Subsequently, the receptacle connector 26 is pushed inward as indicated by a blank arrow in FIG. 5. In a state where the receptacle connector 26 is mounted as illustrated in FIG. 4, the mounted substrate 12 of the present embodiment has the clearance C2 between the depth surface 46a of the connector connecting hole 46 and the distal end surface 32a of the relay connector 32. This allows the receptacle connector 26 (the relay connector 32) to be moved only by the clearance C2 toward the deep side of the connector connecting hole 46.

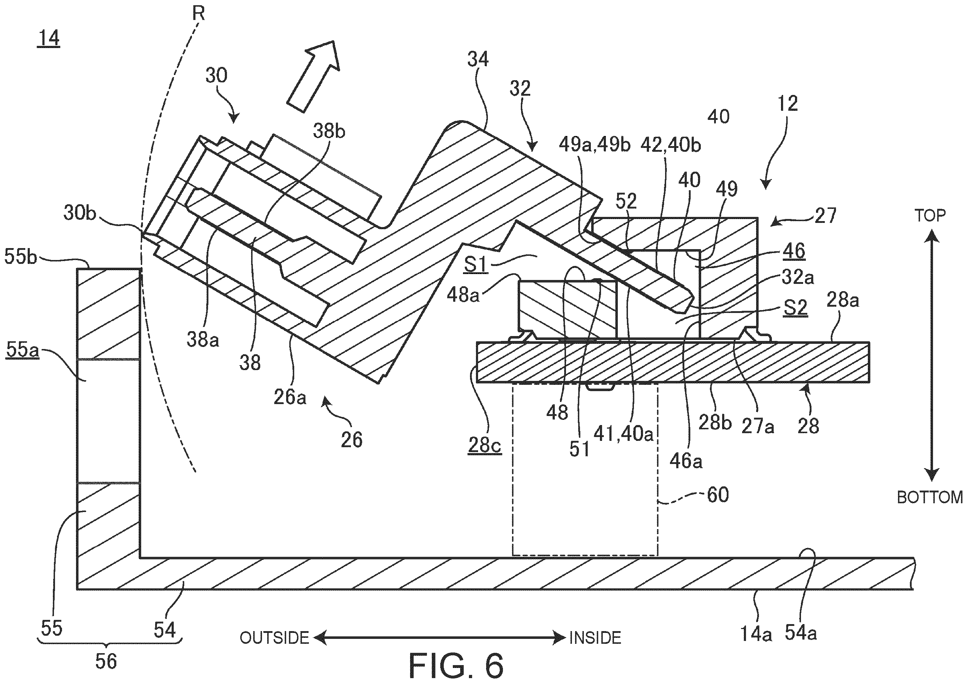

As indicated by a blank arrow in FIG. 6, the receptacle connector 26 is lifted upward with the connecting portion between the relay connector 32 and the connector connecting hole 46 being taken as a pivot point. This causes the receptacle connector 26 to rotate such that an outermost end portion (the outer end surface 30b) draws an arc along a rotation trajectory R as indicated by an alternate long and short dash line in FIG. 6. That is, the receptacle connector 26 tilts up with the connecting portion with the connector connecting hole 46 as the pivot point.

Then, as indicated by a blank arrow in FIG. 7, the receptacle connector 26 is pulled outwardly and diagonally upward from the surface mount connector 27. Hereby, the removal operation of the receptacle connector 26 from the surface mount connector 27 is completed.

As such, in the mounted substrate 12 and the electronic apparatus 10 in the present embodiment, the receptacle connector 26 is not soldered to the substrate 28, so that the receptacle connector 26 can be easily replaced, thereby making it possible to restrain a replacement cost. Besides, the receptacle connector 26 can tilt up relative to the surface mount connector 27. Hereby, the mounted substrate 12 and the electronic apparatus 10 can avoid such a situation that the vertical wall 55 becomes obstructive at the time of replacement of the receptacle connector 26, and the replacement operation can be performed more easily. Besides, the receptacle connector 26 has a horizontal engagement structure in which the receptacle connector 26 is engaged with the surface mount connector 27 in a direction along the surface direction of the substrate 28. Accordingly, the receptacle connector 26 is not put on the surface mount connector 27, so that the height of the mounted substrate 12 does not increase. As a result, the mounted substrate 12 also contributes to a reduction in the thickness of the chassis 14. Since the receptacle connector 26 has a horizontal engagement structure, it is possible to reduce the number of connecting points between the substrate 28 and the receptacle connector 26 and to shorten the length of an electrode line in the receptacle connector 26. On this account, the mounted substrate 12 is also suitable for transmission of a high-speed signal.

At the time of such a removal operation of the receptacle connector 26 from the surface mount connector 27, the electronic apparatus 10 of the present embodiment is preferably configured such that the extension line E1 of the inclined surface 49b does not intersect with the vertical wall 55. The extension line E2 in FIG. 7 is a virtual line parallel to the extension line E1 and passing through a bottom surface 26a of the receptacle connector 26. As illustrated in FIGS. 6 and 7, the electronic apparatus 10 is more preferably configured such that the extension line E2 does not intersect with the vertical wall 55 at a rotation position where the top surface (the other surface 40b) of the board piece 40 of the relay connector 32 makes contact with or comes closer to the inclined surface 49b. Hereby, the electronic apparatus 10 allows the receptacle connector 26 to be easily removed from the surface mount connector 27 while the electronic apparatus 10 avoids the receptacle connector 26 from interfering with the vertical wall 55. Further, the upper end 55b of the vertical wall 55 can be placed below the second edge portion 49a of the connector connecting hole 46, based on the height direction of the connector connecting hole 46. This accordingly makes it possible to further restrain the vertical wall 55 from becoming obstructive at the time when the receptacle connector 26 is pulled out.

In the meantime, in a state where the receptacle connector 26 of the present embodiment is attached as illustrated in FIG. 4, only the slight clearance C1 that is 0.2 mm, for example, is provided between the outer end surface 30b and the inner surface of the vertical wall 55. Hereby, the plug connection opening 30a of the receptacle connector 26 is placed close to the through-hole 55a, thereby preventing the clearance C1 from being outstanding at the time when the through-hole 55a is viewed from outside the chassis 14. In the meantime, assume a case where the receptacle connector 26 is tilted up while the clearance C1 is maintained. In this case, the outer end surface 30b may make contact with the vertical wall 55, and the receptacle connector 26 may not be able to tilt up to a desired angle. The reason is because the outer end surface 30b is placed below the connecting portion between the relay connector 32 and the connector connecting hole 46 which connecting portion serves as the pivot point for rotation.

In view of this, the electronic apparatus 10 of the present embodiment secures the clearance C2 on the deep side from the relay connector 32 in a normal connection state. Hereby, the receptacle connector 26 can be tilted up after the receptacle connector 26 is moved inward. Accordingly, the mounted substrate 12 can narrow the clearance C1 and also avoid the receptacle connector 26 from making contact with the vertical wall 55 at the time when the receptacle connector 26 is tilted up.

In terms of the tilt-up operation, the mounted substrate 12 of the present embodiment can be configured such that the upper and lower edge portions 48a, 49a of the connector connecting hole 46 deviate from each other in the inside-outside direction. The open space S1 is formed in the opening edge portion of the connector connecting hole 46 due to the deviation. Accordingly, the mounted substrate 12 of the present embodiment allows the receptacle connector 26 to smoothly rotate in a state where the relay connector 32 is inserted into the connector connecting hole 46. Besides, the surface mount connector 27 can have the inclined surface 49b in the second edge portion 49a on the upper side of the open space S1. This restrains the rotating relay connector 32 from colliding with the second edge portion 49a of the surface mount connector 27. As a result, the receptacle connector 26 can be smoothly rotated to a desired angle illustrated in FIG. 6, for example.

As illustrated in FIGS. 5 and 6, the surface mount connector 27 can have the expansion space S2 expanding downward, on the deep side from the first contact point 51 in the connector connecting hole 46. Accordingly, it is possible to avoid the board piece 40 of the relay connector 32 from interfering with the first inner surface 48 in the connector connecting hole 46, thereby resulting in that the receptacle connector 26 further smoothly rotates.

Next will be described the attachment operation of the receptacle connector 26.

The attachment operation of the receptacle connector 26 can be performed in a reverse manner to the above removal operation. First, the receptacle connector 26 is moved inwardly and diagonally downward in a direction reverse to the blank arrow in FIG. 7 so as to insert the relay connector 32 into the connector connecting hole 46. Subsequently, the receptacle connector 26 is rotated in a direction reverse to the blank arrow in FIG. 6 so as to move the plug hold cylindrical body 30 downward. Subsequently, the receptacle connector 26 is moved outward in a direction reverse to the blank arrow in FIG. 5, so as to position the plug connection opening 30a at a position facing the through-hole 55a (see FIG. 4).

Finally, the fixing pieces 34a, 34b are fixed to the substrate 28, and the cover material 58 is attached to the chassis member 56. Hereby, the attachment (replacement) operation of the receptacle connector 26 is completed.

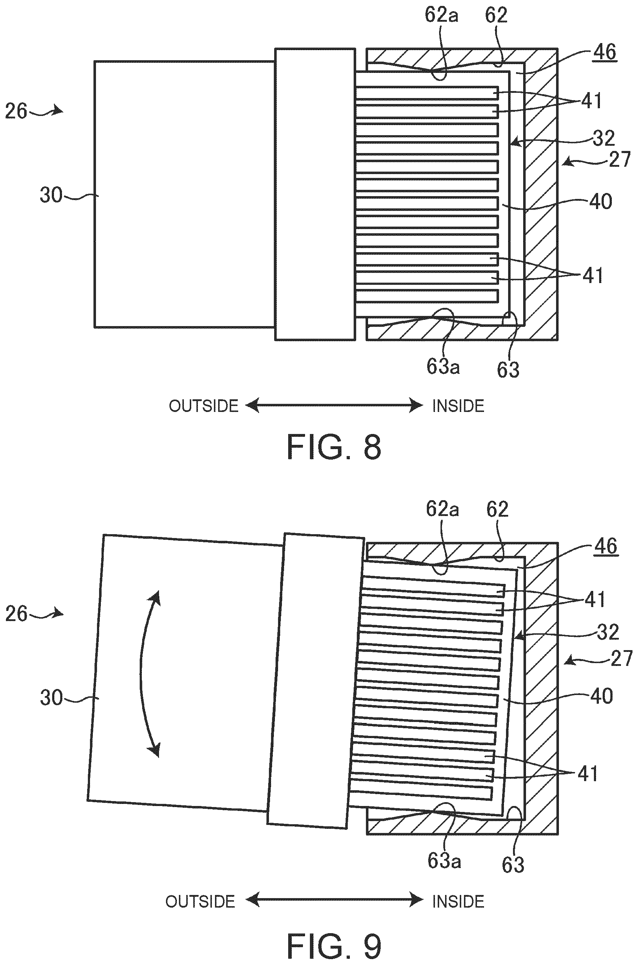

As illustrated in FIGS. 8 and 9, the receptacle connector 26 of the present embodiment can be configured to be adjustable in position in the width direction at the time of positioning to the through-hole 55a.

FIG. 8 is a schematic plan sectional view of the receptacle connector 26 and the surface mount connector 27. FIG. 9 is a view illustrating a state where the receptacle connector 26 illustrated in FIG. 8 is positioned in the width direction on a horizontal plane. The surface mount connector 27 can have projections 62a, 63a on inner surfaces 62, 63 provided in the width direction of the connector connecting hole 46 so as to be along the top-bottom direction. Lateral end surfaces of the board piece 40 of the relay connector 32 abut with the projections 62a, 62b. Hereby, the receptacle connector 26 can also swing in the width direction in a state where the relay connector 32 is inserted into the connector connecting hole 46. That is, the plug connection opening 30a can be also adjusted in position in the width direction relative to the through-hole 55a. Hereby, the receptacle connector 26 can be highly precisely positioned relative to the through-hole 55a.

Note that it is needless to say that the present invention is not limited to the above embodiment and is freely modifiable without departing from the gist of the present invention.

### Description of Symbols

- 10: electronic apparatus
- 12: mounted substrate
- 14: chassis
- 26: receptacle connector
- 27: surface mount connector
- 28: substrate
- 28a: mounting surface
- 30: plug hold cylindrical body
- 30a: plug connection opening
- 32: relay connector
- 41: first terminal
- 42: second terminal
- 48: first inner surface
- 48a: first edge portion
- 49: second inner surface
- 49a: second edge portion
- 49b: inclined surface
- 46: connector connecting hole
- 51: first contact point
- 52: second contact point
- 54: plate portion
- 55: vertical wall
- 55a: through-hole
- S1: open space
- S2: expansion space

## Claims

1. A mounted substrate (12) comprising:
a substrate (28) comprising a mounting surface (28a) ;
a surface mount connector (27) comprising an inner surface provided with a contact point and a connector connecting hole (46) opened along a surface direction of the substrate, and mounted on the mounting surface of the substrate; and
a receptacle connector (26) comprising a plug connection opening (30a) to which a plug is connectable, the receptacle connector including a relay connector (32) detachably connected to the connector connecting hole, wherein:
the connector connecting hole comprises an opening edge portion including
a first edge portion (48a) placed in proximity to the mounting surface side in a height direction of the connector connecting hole, and
a second edge portion (49a) placed opposite from the first edge portion in the height direction; and wherein
the second edge portion is disposed on a deep side from the first edge portion in a depth direction of the connector connecting hole.

2. The mounted substrate according to claim 1, wherein the second edge portion comprises an inclined surface (49b) inclined in a direction separating from the mounting surface, from the deep side toward an opening side in the connector connecting hole.

3. The mounted substrate according to claim 1, comprising a clearance where the relay connector is movable is provided between a depth surface of the connector connecting hole and a distal end surface of the relay connector connected to the connector connecting hole.

4. The mounted substrate according to any one of claims 1 to 3, wherein:
the contact point includes
a first contact point (51) provided on a first inner surface of the connector connecting hole which first inner surface extends from the first edge portion toward the deep side, and
a second contact point (52) provided on a second inner surface of the connector connecting hole which second inner surface extends from the second edge portion toward the deep side; and
the connector connecting hole comprises an expansion space (S2) formed such that a portion of the first inner surface which portion is on the deep side from the first contact point is recessed toward the mounting surface side in the height direction.

5. The mounted substrate according to claim 4, wherein the second contact point is disposed on the deep side from the first contact point in the depth direction.

6. An electronic apparatus (10) comprising:
a chassis (14); and
a mounted substrate (12) supported on the chassis, wherein:
the mounted substrate includes
a substrate (28) comprising a mounting surface (28a),
a surface mount connector (27) comprising an inner surface provided with a contact point and a connector connecting hole (46) opened along a surface direction of the substrate, and mounted on the mounting surface of the substrate, and
a receptacle connector (26) comprising a plug connection opening (30a) to which a plug is connectable, the receptacle connector including a relay connector (32) detachably connected to the connector connecting hole;
wherein the connector connecting hole comprises an opening edge portion including
a first edge portion (48a) placed in proximity to the mounting surface side in a height direction of the connector connecting hole, and
a second edge portion (49a) is disposed opposite from the first edge portion in the height direction; and
the second edge portion is disposed on a deep side from the first edge portion in a depth direction of the connector connecting hole.

7. The electronic apparatus according to claim 6, wherein the second edge portion comprises an inclined surface (49b) inclined in a direction separating from the mounting surface, from the deep side toward an opening side in the connector connecting hole.

8. The electronic apparatus according to claim 7, wherein:
the chassis includes
a plate portion (54) supporting a surface of the substrate which surface is opposite from the mounting surface, and
a wall (55) comprising a through-hole that the plug connection opening is disposed to face, the wall being provided in a standing manner from an edge portion of the plate portion; wherein
an extension line from the inclined surface does not intersect with the wall.

9. The electronic apparatus according to claim 8, wherein the wall comprises an upper end placed below the second edge portion of the connector connecting hole, based on the height direction of the connector connecting hole.

10. The electronic apparatus according to claim 8, comprising:
a clearance where the relay connector is movable is provided between a depth surface of the connector connecting hole and a distal end surface of the relay connector connected to the connector connecting hole; wherein
the clearance is larger than an opposed distance between the wall and the plug connection opening.

11. The electronic apparatus according to any one of claims 7 to 10, wherein:
the contact point includes
a first contact point (51) provided on a first inner surface of the connector connecting hole which first inner surface extends from the first edge portion toward the deep side, and
a second contact point (52) provided on a second inner surface of the connector connecting hole which second inner surface extends from the second edge portion toward the deep side; and
the connector connecting hole comprises an expansion space (S2) formed such that a portion of the first inner surface which portion is on the deep side from the first contact point is recessed toward the mounting surface side in the height direction.

12. The electronic apparatus according to claim 11, wherein the second contact point is disposed on the deep side from the first contact point in the depth direction.
